# EUROPÄISCHE PATENTSCHRIFT

(11) **EP 1 439 586 B1**
(45) Veröffentlichungstag und Bekanntmachung des Hinweises auf die Patenterteilung: **12.03.2014**
(21) Anmeldenummer: 04008348.7
(22) Anmeldetag: 26.06.1997
(51) Int. Cl.: C09K 11/77, H01L 33/48, H01L 33/50, H01L 33/56

(54) **Licht abstrahlendes Halbleiterbauelement mit Lumineszenzkonversionselement**
Light-emitting semiconductor component with luminescence conversion element
Composant à semi-conducteur luminescent avec élément de conversion de la luminescence

(30) Priorität: 26.06.1996 DE 19625622; 20.09.1996 DE 19638667
(43) Veröffentlichungstag der Anmeldung: 21.07.2004
(62) Teilanmeldung aus: 97931666.8
(73) Patentinhaber: OSRAM Opto Semiconductors GmbH, 93055 Regensburg (DE)
(72) Erfinder: Schlotter, Peter, 79112 Freiburg (DE); Reeh, Ulrike, 80995 München (DE); Schmidt, Ralf, 79279 Vörstetten (DE); Schneider, Jürgen, 99117 Freiburg (DE); Höhn, Klaus, 81301 Forchheim (DE); Stath, Norbert, 93049 Regensburg (DE); Waitl, Günter, 93049 Regensburg (DE)
(74) Vertreter: Epping - Hermann - Fischer

(56) Entgegenhaltungen:
- EP-A- 0 936 682
- DE-U1- 9 013 615
- JP-A- H 087 614
- US-A- 4 599 537
- SCHREIBEN VON HERR WUSTLICH/WUSTLICH MICRO/OPTO-ELEKTRONIK GMBH AN HERR MENDEN/MENDEN BUCHSTABEN, 22. September 1995 (1995-09-22), XP002324886
- PATENT ABSTRACTS OF JAPAN Bd. 017, Nr. 542 (E-1441), 29. September 1993 (1993-09-29) -& JP 05 152609 A (NICHIA CHEM IND LTD), 18. Juni 1993 (1993-06-18)
- MÖLLMER F ET AL: "Siemens SMT-TOPLED für die Oberflächenmontage" SIEMENS COMPONENTS GERMANY, Bd. 29, Nr. 4, 1991, Seiten 147-149, XP002324887
- PATENT ABSTRACTS OF JAPAN Bd. 1996, Nr. 07, 31. Juli 1996 (1996-07-31) -& JP 08 064860 A (MITSUBISHI MATERIALS CORP), 8. März 1996 (1996-03-08)
- PATENT ABSTRACTS OF JAPAN Bd. 003, Nr. 089 (E-126), 28. Juli 1979 (1979-07-28) -& JP 54 066093 A (TOSHIBA CORP), 28. Mai 1979 (1979-05-28)
- MOELLMER F ET AL: "SIEMENS SMT TOP-LED FOR SURFACE MOUNTING" SIEMENS COMPONENTS, SIEMENS VERLAG, ERLANGEN, DE, Bd. 26, Nr. 6, 1991, Seiten 193-196, XP000874796 ISSN: 0173-1726
- PATENT ABSTRACTS OF JAPAN Bd. 1995, Nr. 10, 30. November 1995 (1995-11-30) -& JP 07 176794 A (NICHIA CHEM IND LTD), 14. Juli 1995 (1995-07-14)

## Beschreibung

Die Erfindung bezieht sich auf ein lichtabstrahlendes Halbleiterbauelement nach dem Oberbegriff des Patentanspruches 1.

Ein derartiges Halbleiterbauelement ist beispielsweise aus der Offenlegungsschrift DE 38 04 293 und dem Gebrauchsmuster DE-U-90 13 615 bekannt. In diesen ist jeweils eine Anordnung mit einer Elektrolumineszenz- oder Laserdiode beschrieben, bei der das gesamte von der Diode abgestrahlte Emmissionsspektrum mittels eines mit einem fluoreszierenden, lichtwandelnden organischen Farbstoff versetzten Elements aus Kunststoff zu größeren Wellenlängen hin verschoben wird. Das von der Anordnung abgestrahlte Licht weist dadurch eine andere Farbe auf als das von der Leuchtdiode ausgesandte. Abhängig von der Art des dem Kunststoff beigefügten Farbstoffes lassen sich mit ein und demselben Leuchtdiodentyp Leuchtdiodenanordnungen herstellen, die in unterschiedlichen Farben leuchten.

Aus DE-OS 2 347 289 ist eine Infrarot(IR)-Festkörperlampe bekannt, bei der an der Kante einer IR-Diode Leuchtstoff-Material angebracht ist, das die dort abgestrahlte IR-Strahlung in sichtbares Licht umwandelt. Ziel dieser Maßnahme ist es, zu Kontrollzwecken einen möglichst geringen Teil der von der Diode abgegebenen IR-Strahlung bei gleichzeitig möglichst geringer Verminderung der Intensität der abgegebenen IR-Strahlung in sichtbares Licht umzuwandeln.

Die US-A-4 599 537 beschreibt eine gleichzeitig infrarote Strahlung und sichtbare Strahlung emittierende Anordnung, bei der ein Teil der Strahlung eines infrarot emittierenden Elements mittels einer fluoreszierenden Substanz in sichtbare' Strahlung konvertiert wird, um den Betriebszustand des infrarot emittierenden Elements sichtbar zu machen.

Weiterhin ist aus der EP 486 052 eine lichtemittierende Diode bekannt, bei der zwischen dem Substrat und einer aktiven elektrolumineszierenden Schicht mindestens eine Halbleiter-Photolumineszenzschicht angeordnet ist, die das von der aktiven Schicht in Richtung Substrat ausgesandte Licht eines ersten wellenlängenbereichs in Licht eines zweiten wellenlängenbereichs umwandelt, so daß die lichtemittierende Diode insgesamt Licht verschiedener Wellenlängenbereiche aussendet.

In der JP-A-5 152 609 ist eine Leuchtdiode beschrieben, bei der zur Verbesserung von Sichtbarkeit und Helligkeit des abgestrahlten Lichtes mittels einer fluoreszierenden Substanz kurzwellige UV- und/oder violette Strahlung in längerwellige blaue Strahlung umgewandelt wird. In vielen potentiellen Anwendungsgebieten für Leuchtdioden, wie zum Beispiel bei Anzeigeelementen im Kfz-Armaturenbrett, Beleuchtung in Flugzeugen und Autos und bei vollfarbtauglichen LED-Displays, tritt verstärkt die Forderung nach Leuchtdiodenanordnungen auf, mit denen sich mischfarbiges Licht, insbesondere weißes Licht erzeugen läßt.

In JP-A-7 176 794-A und in JP-A-8 007 614 ist jeweils eine weißes Licht aussendende planare Lichtquelle beschrieben, bei der an einer Stirnseite einer transparenten Platte blaues Licht emittierende Dioden angeordnet sind, die Licht in die transparente Platte hinein aussenden. Die transparente Platte ist auf einer der beiden einander gegenüberliegenden Hauptflächen mit einer fluoreszierenden Substanz beschichtet, die Licht emittiert, wenn sie mit dem blauen Licht der Dioden angeregt wird. Das von der fluoreszierenden Substanz emittierte Licht hat eine andere Wellenlänge als das von den Dioden emittierte blaue Licht. Bei diesem bekannten Bauelement ist es besonders schwierig, die fluoreszierende Substanz in einer Art und Weise aufzubringen, daß die Lichtquelle homogenes weißes Licht abstrahlt. Darüber hinaus bereitet auch die Reproduzierbarkeit in der Massenfertigung große Probleme, weil schon geringe Schichtdicken schwankungen der fluoreszierenden Schicht, z. B. aufgrund von Unebenheiten der Oberfläche der transparenten Platte, eine Änderung des weißtones des abgestrahlten Lichtes hervorruft.

Der vorliegenden Erfindung liegt die Aufgabe zugrunde, ein Halbleiterbauelement der eingangs genannten Art zu entwickeln, das homogenes mischfarbiges Licht abstrahlt und das eine techriisch einfache Massenfertigung mit weitestgehend reproduzierbarer Bauelementcharakteristik gewährleistet.

Diese Aufgabe wird durch ein Halbleiterbauelement nach Anspruch 1 gelöst. Vorteilhafte weiterbildungen der Erfindung sind Gegenstand der Unteransprüche 2 bis 12.

Es ist insbesondere vorgesehen, daß der strahlungsemittierende Halbleiterkörper eine Schichtenfolge, insbesondere eine Schichtenfolge mit einer aktiven Halbleiterschicht aus GaₓIn₁₋ₓN oder GaₓAl₁₋ₓN aufweist, die im Betrieb des Halbleiterbauelements eine elektromagnetische Strahlung eines ersten Wellenlängenbereiches aus dem ultravioletten, blauen und/oder grünen Spektralbereich aussendet. Das Lumineszenzkonversionselement wandelt einen Teil der aus dem ersten Wellenlängenbereich stammenden Strahlung in Strahlung eines zweiten Wellenlängenbereiches um, derart, daß das Halbleiterbauelement Mischstrahlung, insbesondere mischfarbiges Licht, bestehend aus Strahlung des ersten wellenlängenbereiches und Strahlung des zweiten Wellenlängenbereiches aussendet. Das heißt beispielsweise, daß das Lumineszenzkonversionselement einen Teil der vom Halbleiterkörper ausgesandten Strahlung bevorzugt nur über einen spektralen Teilbereich des ersten Wellenlängenbereichs spektral selektiv absorbiert und im längerwelligen Bereich (im zweiten Wellenlängenbereich) emittiert. Dabei weist die von dem Halbleiterkörper ausgesandte Strahlung bei einer wellenlänge λ ≤ 520 nm ein relatives Intensitätsmaximum auf und liegt der von dem Lumineszenzkonversionselement spektral selektiv absorbierte Wellenlängenbereich außerhalb dieses Intensitätsmaximums.

Ebenso kann vorteilhafterweise mit der Erfindung auch eine Anzahl (einer oder mehrere) von aus dem ersten Wellenlängenbereich stammenden ersten spektralen Teilbereichen in mehrere zweite wellenlängenbereiche umgewandelt werden. Dadurch ist es vorteilhafterweise möglich, vielfältige Farbmischungen und Farbtemperaturen zu erzeugen.

Das erfindungsgemäße Halbleiterbauelement hat den besonderen Vorteil, daß das über Lumineszenzkonversion erzeugte Wellenlängenspektrum und damit die Farbe des abgestrahlten Lichtes nicht von der Höhe der Betriebsstromstärke durch den Halbleiterkörper abhängt. Dies hat insbesondere dann große Bedeutung, wenn die Umgebungstemperatur des Halbleiterbauelementes und folglich bekanntermaßen auch die Betriebsstromstärke stark schwankt. Besonders Leuchtdioden mit einem Halbleiterkörper auf der Basis von GaN sind diesbezüglich sehr empfindlich.

Außerdem benötigt das erfindungsgemäße Halbleiterbauelement nur eine einzige Ansteuerspannung und damit auch nur eine einzige Ansteuerschaltungsanordnung, wodurch der Bauteileaufwand für die Ansteuerschaltung des Halbleiterbauelements sehr gering gehalten werden kann.

Bei einer besonders bevorzugten Ausführungsform der Erfindung ist als Lumineszenzkonversionselement über oder auf dem Halbleiterkörper eine teiltransparente, d. h. eine für die von dem Strahlung aussendenden Halbleiterkörper ausgesandte Strahlung teilweise transparente Lumineszenzkonversionsschicht vorgesehen. Um eine einheitliche Farbe des abstrahlten Lichtes sicherzustellen, ist vorteilhafterweise die Lumineszenzkonversionsschicht derart ausgebildet, daß sie durchweg eine konstante Dicke aufweist. Dies hat den besonderen Vorteil, daß die Weglänge des von dem Halbleiterkörper abgestrahlten Lichtes durch die Lumineszenzkonversionsschicht hindurch für alle Strahlungsrichtungen nahezu konstant ist. Dadurch kann erreicht werden, daß das Halbleiterbauelement in alle Richtungen Licht derselben Farbe abstrahlt. Ein weiterer besonderer Vorteil eines erfindungsgemäßen Halbleiterbauelements gemäß dieser Weiterbildung besteht darin, daß auf einfache weise eine hohe Reproduzierbarkeit erzielt werden kann, was für eine effiziente Massenfertigung von wesentlicher Bedeutung ist.

Eine andere bevorzugte Ausführungsform des erfindungsgemäßen Halbleiterbauelementes weist als Lumineszenzkonversionselement eine teiltransparente Lumineszenzkonversionsumhüllung auf, die zumindest einen Teil des Halbleiterkörpers (und evtl. Teilbereiche der elektrischen Anschlüsse) umschließt und gleichzeitig als Bauteilumhüllung (Gehäuse) genutzt sein kann. Der Vorteil eines Halbleiterbauelements gemäß dieser Ausführungsform besteht im wesentlichen darin, dass zu seiner Herstellung konventionelle, für die Herstellung von herkömmlichen Leuchtdioden (z. B. Radial-Leuchdioden) eingesetzte Produktionslinien genutzt werden können. Für die Bauteilumhüllung ist anstelle des bei herkömmlichen Leuchtdioden dafür verwendeten transparenten Kunststoffes das Material der Lumineszenzkonversionsumhüllung verwendet.

Die Lumineszenzkonversionsschicht bzw. die Lumineszenzkonversionsumhüllung besteht aus einem transparenten Silikonmaterial, das mit mindestens einem Leuchtstoff versehen ist. Auf diese Weise lassen sich Lumineszenzkonversionselemente besonders kostengünstig herstellen. Die dazu notwendigen Verfahrensschritte sind nämlich ohne großen Aufwand in herkömmliche Produktionslinien für Leuchtdioden integrierbar.

Bei einer besonders bevorzugten Weiterbildung der Erfindung bzw. der o. g. Ausführungsformen ist vorgesehen, daß der oder die zweiten Wellenlängenbereiche im Wesentlichen größere Wellenlängen aufweisen als der erste Wellenlängenbereich.

Insbesondere ist vorgesehen, daß ein zweiter spektraler Teilbereich des ersten Wellenlängenbereiches und ein zweiter wellenlängenbereich zueinander komplementär sind. Auf diese weise kann aus einer einzigen farbigen Lichtquelle, insbesondere einer Leuchtdiode mit einem einzigen blaues Licht abstrahlenden Halbleiterkörper, mischfarbiges, insbesondere weißes Licht erzeugt werden. Um z. B. mit einem blaues Licht aussendenden Halbleiterkörper weißes Licht zu erzeugen, wird ein Teil der von dem Halbleiterkörper ausgesandten Strahlung aus dem blauen Spektralbereich in den zu Blau komplementärfarbigen gelben Spektralbereich konvertiert. Die Farbtemperatur oder Farbort des weißen Lichtes kann dabei durch geeignete Wahl des Lumineszenzkonversionselementes, insbesondere durch eine geeignete Wahl des Leuchtstoffes, dessen Partikelgröße und dessen Konzentration, variiert werden. Darüberhinaus bieten diese Anordnungen vorteilhafterweise auch die Möglichkeit, Leuchtstoffmischungen einzusetzen, wodurch sich vorteilhafterweise der gewünschte Farbton sehr genau einstellen läßt. Ebenso können Lumineszenzkonversionselemente inhomogen ausgestaltet sein, z. B. mittels einer inhomogenen Leuchtstoffverteilung. Unterschiedliche weglängen des Lichtes durch das Lumineszenzkonversionselement können dadurch vorteilhafterweise kompensiert werden.

Bei einer weiteren bevorzugten Ausführungsform des erfindungsgemäßen Halbleiterbauelements weist das Lumineszenzkonversionselement oder ein anderer Bestandteil einer Bauteilumhüllung zur Farbanpassung einen oder mehrere Farbstoffe auf, die keine Wellenlängenkonversion bewirken. Hierzu können die für die Herstellung von herkömmlichen Leuchdioden verwendeten Farbstoffe wie z. B. Azo-, Anthrachinon- oder Perinon-Farbstoffe eingesetzt werden.

Zum Schutz des Lumineszenzkonversionselements vor einer zu hohen Strahlenbelastung ist bei einer vorteilhaften Weiterbildung bzw. bei den o. g. bevorzugten Ausführungsformen des erfindungsgemäßen Halbleiterbauelements zumindest ein Teil der Oberflache des Halbleiterkörpers von einer ersten, z. B. aus einem Kunststoff bestehenden transparenten Hülle umgeben, auf der die Lumineszenzkonversionsschicht aufgebracht ist. Dadurch wird die Strahlungsdichte im Lumineszenzkonversionselement und somit dessen Strahlungsbelastung verringert, was sich je nach verwendeten Materialien positiv auf die Lebensdauer des Lumineszenzkonversionselementes auswirkt.

Bei einer besonders bevorzugten Ausgestaltung der Erfindung sowie der oben genannten Ausführungsformen ist ein strahlungsemittierender Halbleiterkörper verwendet, bei dem das ausgesandte Strahlungsspektrum bei einer Wellenlänge zwischen 420nm und 460 nm, insbesondere bei 430 nm (z. B. Halbleiterkörper auf der Basis von GaₓAl₁₋ₓN) oder 450 nm (z. B. Halbleiterkörper auf der Basis von GaₓIn₁₋ₓN) ein Intensitätsmaximum aufweist. Mit einem derartigen erfindungsgemäßen Halbleiterbauelement lassen sich vorteilhafterweise nahezu sämtliche Farben und Mischfarben der C.I.E.-Farbtafel erzeugen. Der strahlungsemittierende Halbleiterkörper kann hierbei, wie oben angegeben, im Wesentlichen aus elektrolumineszierendem Halbleitermaterial aber auch aus einem anderen elektrolumineszierenden Material, wie beispielsweise Polymermaterial bestehen.

Die Lumineszenzkonversionsumhüllung bzw. die Lumineszenzkonversionsschicht ist aus einem für die Umhüllung optoelektronischer Bauelemente eingesetzten Silikonmaterial hergestellt. Silikon lässt sich auf einfache weise mit einem oder mehreren Leuchtstoffen versetzen.

Besonders einfach läßt sich ein erfindungsgemäßes Halbleiterbauelement dann realisieren, wenn der Halbleiterkörper in einer Ausnehmung eines gegebenenfalls vorgefertigten Gehäuses angeordnet ist und die Ausnehmung mit einem die Lumineszenzkonversionsschicht aufweisenden Abdeckelement versehen ist. Ein derartiges Halbleiterbauelement läßt sich in großer Stückzahl in herkömmlichen Produktionslinien herstellen. Hierzu muß lediglich nach der Montage des Halbleiterkörpers in das Gehäuse das Abdeckelement, auf das Gehäuse aufgebracht werden. Optional kann die Ausnehmung des Gehäuses mit einem transparenten Material, beispielsweise einem transparenten Kunststoff, gefüllt sein, das insbesondere die Wellenlänge des von dem Halbleiterkörper ausgesandten Lichtes nicht verändert oder aber, falls gewünscht, bereits lumineszenzkonvertierend ausgebildet sein kann.

Bei einer aufgrund besonders einfacher Realisierbarkeit besonders bevorzugten Weiterbildung des erfindungsgemäßen Halbleiterbauelements ist der Halbleiterkörper in einer Ausnehmung eines gegebenenfalls vorgefertigten eventuell bereits mit einem Leadframe versehenen Gehäuses angeordnet und ist die Ausnehmung mit einem zumindest teiltransparenten Silikonmaterial gefüllt, dem der Leuchtstoff bereits vor dem Ausgießen der Ausnehmung zugefügt ist. Das Lumineszenzkonversionselement ist hier somit von dem mit Leuchtstoff versehenen Verguß des Halbleiterkörpers versehen.

Infrarot strahlende erfindungsgemäße Halbleiterbauelemente, insbesondere mit blaues Licht aussendenden Halbleiterkörpern, können mittels Beimischung von Ti³⁺-dotiertem Saphir hergestellt werden.

Ein weißes Licht abstrahlendes erfindungsgemäßes Halbleiterbauelement läßt sich vorteilhafterweise dadurch herstellen, daß der Leuchtstoff so gewählt wird, daß eine von dem Halbleiterkörper ausgesandte blaue Strahlung in komplementäre Wellenlängenbereiche, insbesondere Blau und Gelb, oder zu additiven Farbtripeln, z. B. Blau, Grün und Rot umgewandelt wird. Hierbei wird das gelbe bzw. das grüne und rote Licht über die Leuchtstoffe erzeugt. Der Farbton (Farbort in der CIE-Farbtafel) des dadurch erzeugten weißen Lichts kann dabei durch geeignete Wahl des/der Farbstoffes/e hinsichtlich Mischung und Konzentration variiert werden.

Bei einer weiteren bevorzugten Weiterbildung eines erfindungsgemäßen Halbleiterbauelements bzw. der oben angegebenen vorteilhaften Ausführungsformen sind dem Lumineszenzkonversionselement oder einer anderen strahlungsdurchlässigen Komponente der Bauteilumhüllung zusätzlich lichtstreuende Partikel, sogenannte Diffusoren zugesetzt. Hierdurch läßt sich vorteilhafterweise der Farbeindruck und die Abstrahlcharakteristik des Halbleiterbauelements optimieren.

Um die Durchmischung der von dem Halbleiterkörper ausgesandten Strahlung des ersten Wellenlängenbereiches mit der lumineszenz konvertierten Strahlung des zweiten Wellenlängebereiches und damit die Farbhomogenität des abstrahlten Lichtes zu verbessern, ist bei einer vorteilhaften Ausgestaltung des erfindungsgemäßen Halbleiterbauelements der Lumineszenzumhüllung bzw. der Lumineszenzkonversionsschicht und/oder einer anderen Komponente der Bauteilumhüllung zusätzlich ein im Blauen lumineszierender Farbstoff zugefügt, der eine sogenannte Richtcharakteristik der von dem Halbleiterkörper abgestrahlten Strahlung abschwächt. Unter Richtcharakteristik ist zu verstehen, daß die von dem Halbleiterkörper ausgesandte Strahlung eine bevorzugte Abstrahlrichtung aufweist.

Bei einer weiteren bevorzugten Weiterbildung eines erfindungsgemäßen Halbleiterbauelements bzw. der oben angegebenen vorteilhaften Ausführungsformen sind dem Lumineszenzkonversionselement oder einer anderen strahlungsdurchlässigen Komponente der Bauteilumhüllung zusätzlich lichtstreuende Partikel, sogenannte Diffusoren zugesetzt. Hierdurch läßt sich vorteilhafterweise der Farbeindruck und die Abstrahlcharakteristik des Halbleiterbauelements weiter optimieren.

Von besonderem Vorteil ist, daß die Leuchteffizienz von weißleuchtenden erfindungsgemäßen Halbleiterbauelementen bzw. deren o. g. Ausführungsformen mit einem im wesentlichen auf der Basis von GaN hergestellten blau leuchtenden Halbleiterkörper gegenüber der Leuchteffizienz einer Glühbirne erheblich erhöht ist. Der Grund dafür besteht darin, daß zum einen die externe Quantenausbeute derartiger Halbleiterkörper bei einigen Prozent liegt und andererseits die Lumineszenzausbeute von organischen Farbstoff-Molekülen oft bei über 90% angesiedelt ist. Darüberhinaus zeichnet sich das erfindungsgemäße Halbleiterbauelement im vergleich zur Glühbirne durch eine extrem lange Lebensdauer, größere Robustheit und eine kleinere Betriebsspannung aus.

Vorteilhaft ist weiterhin, daß die für das menschliche Auge wahrnehmbare Helligkeit des erfindungsgemäßen Halbleiterbauelements gegenüber einem ohne Lumineszenzkonversionselement ausgestatteten, aber sonst identischen Halbleiterbauelement deutlich erhöht werden kann, da die Augenempfindlichkeit zu höherer Wellenlänge hin zunimmt.

Darüberhinaus kann mit dem erfindungsgemäßen Prinzip Vorteilhafterweise auch eine von dem Halbleiterkörper neben der sichtbaren Strahlung ausgesandte ultraviolette Strahlung in sichtbares Licht umgewandelt werden. Dadurch wird die Helligkeit des vom Halbleiterkörper ausgesandten Lichts deutlich erhöht.

Das hier vorgestellte Konzept der Lumineszenzkonversion mit blauem Licht eines Halbleiterkörpers läßt sich vorteilhafterweise auch auf mehrstufige Lumineszenzkonversionselemente erweitern, nach dem Schema ultraviolett → blau → grün → gelb → rot. Hierbei werden eine Mehrzahl von spektral selektiv emittierenden Lumineszenzkonversionselementen relativ zum Halbleiterkörper hintereinander angeordnet.

Ebenso können vorteilhafterweise mehrere unterschiedlich spektral selektiv emittierende Farbstoffmoleküle gemeinsam in einen transparenten Kunststoff eines Lumineszenzkonversionselements eingebettet sein. Hierdurch ist ein sehr breites Farbenspektrum erzeugbar.

Besonders vorteilhaft lassen sich erfindungsgemäße Halbleiterbauelemente insbesondere aufgrund ihrer:geringen Leistungsaufnahme in vollfarbtauglichen LED-Displays, zur Beleuchtung von Kfz-Innenräumen oder von Flugzeugkabinen sowie zur Beleuchtung von Anzeigevorrichtungen wie Kfz-Armaturen oder Flüssigkristallanzeigen verwenden.

Weitere Merkmale, Vorteile und Zweckmäßigkeiten der Erfindung ergeben sich aus der nachfolgenden Beschreibung von 9 Ausführungsbeispielen in Verbindung mit den Figuren 1 bis 14. Es zeigen:
Figur 1 eine schematische Schnittansicht eines ersten Ausführungsbeispieles eines erfindungsgemäßen Halbleiterbauelements;
Figur 2 eine schematische Schnittansicht eines zweiten Ausführungsbeispieles eines erfindungsgemäßen Halbleiterbauelementes;
Figur 3 eine schematische Schnittansicht durch ein drittes Ausführungsbeispiel eines erfindungsgemäße Halbleiterbauelementes;
Figur 4 eine schematische Schnittansicht eines vierten Ausführungsbeispieles eines erfindungsgemäßen Halbleiterbauelements;
Figur 5 eine schematische Schnittansicht eines fünften Ausführungsbeispieles eines erfindungsgemäßen Halbleiterbauelementes;
Figur 6 eine schematische Schnittansicht eines sechsten Ausführungsbeispieles eines erfindungsgemäßen Halbleiterbauelementes;
Figur 7 eine schematische Darstellung eines Emissionsspektrums eines blaues Licht abstrahlenden Halbleiterkörpers mit einer Schichtenfolge auf der Basis von GaN;
Figur 8 eine schematische Darstellung der Emissionsspektren zweier erfindungsgemäßer Halbleiterbauelemente, die weißes Licht abstrahlen;
Figur 9 eine schematische Schnittdarstellung durch einen Halbleiterkörper, der blaues Licht aussendet;
Figur 10 eine schematische Schnittansicht eines siebten Ausführungsbeispieles eines erfindungsgemäßen Halbleiterbauelementes;
Figur 11 eine schematische Darstellung eines Emissionsspektrums eines erfindungsgemäßen Halbleiterbauelementes, das mischfarbiges rotes Licht abstrahlt;
Figur 12 eine schematische Darstellung der Emissionsspektren von weiteren erfindungsgemäßen Halbleiterbauelementen, die weißes Licht abstrahlen;
Figur 13 eine schematische Schnittansicht eines achten Ausführungsbeispieles eines erfindungsgemäßene Halbleiterbauelementes und
Figur 14 eine schematische Schnittansicht eines neunten Ausführungsbeispieles eines erfindungsgemäßen Halbleiterbauelementes.

In den verschiedenen Figuren sind gleiche bzw. gleichwirkende Teile immer mit denselben Bezugszeichen bezeichnet.

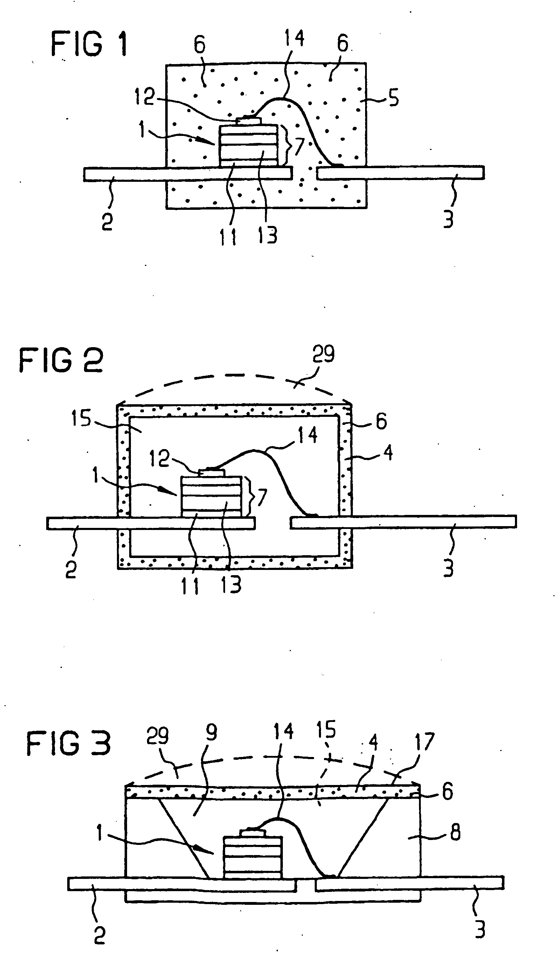

Bei dem in Figur 1 dargestellten Licht aussendenden Halbleiterbauelement weist ein Halbleiterkörper 1 einen Rückseitenkontakt 11, einen Vorderseitenkontakt 12 und eine sich aus einer Anzahl von unterschiedlichen Schichten zusammensetzende Schichtenfolge 7 auf, die im Betrieb des Halbleiterbauelements mindestens eine eine Strahlung (z. B. ultraviolett, blau oder grün) aussendende aktive Zone besitzt.

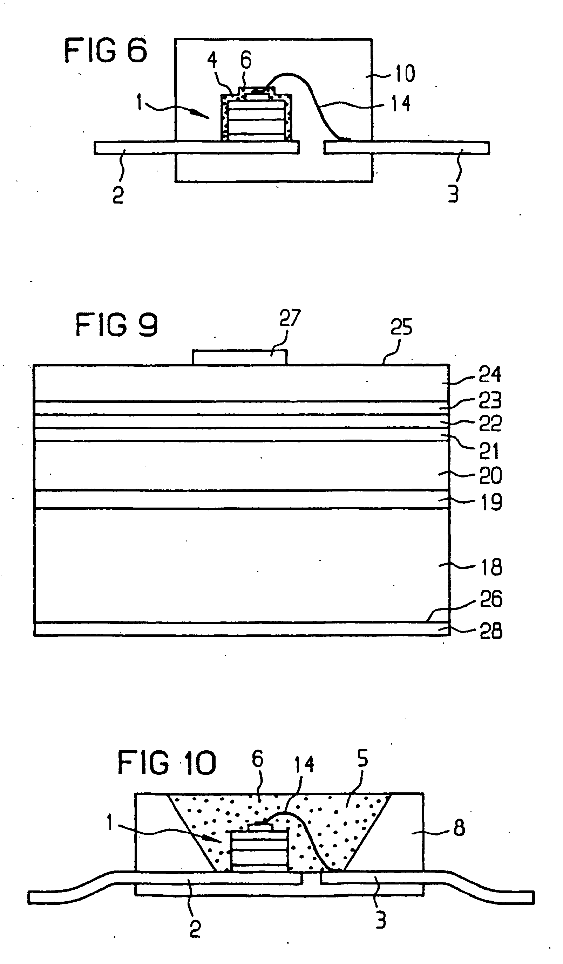

Ein Beispiel für eine geeignete Schichtenfolge 7 für dieses und für sämtliche im folgenden beschriebenen Ausführungsbeispiele ist in Figur 9 gezeigt. Hierbei ist auf einem Substrat 18, das z. B. aus SiC besteht, eine Schichtenfolge aus einer AIN- oder GaN-Schicht 19, einer n-leitenden GaN-Schicht 20, einer n-leitenden GaₓAl₁₋ₓN- oder GaₓIn₁₋ₓN-Schicht 21, einer weiteren n-leitenden GaN- oder einer GaₓIn₁₋ₓN-Schicht 22, einer p-leitenden GaₓAl₁₋ₓN- oder GaₓIn₁₋ₓN-Schicht 23 und einer p-leitenden GaN-Schicht 24 aufgebracht. Auf einer Hauptfläche 25 der p-leitenden GaN-Schicht 24 und einer Hauptfläche 26 des Substrats 18 ist jeweils eine Kontaktmetallisierung 27, 28 aufgebracht, die aus einem herkömmlich in der Opto-Halbleitertechnik für elektrische Kontakte verwendeten Werkstoff besteht.

Es kann jedoch auch jeder andere dem Fachmann für das erfindungsgemäße Halbleiterbauelement als geeignet erscheinende Halbleiterkörper verwendet werden. Dies gilt ebenso für sämtliche nachfolgend beschriebenen Ausführungsbeispiele.

Im Ausführungsbeispiel von Figur 1 ist der Halbleiterkörper 1 mittels eines elektrisch leitenden Verbindungsmittels, z. B. ein metallisches Lot oder ein Klebstoff, mit seinem Rückseitenkontakt 11 auf einem ersten elektrischen Anschluß 2 befestigt. Der Vorderseitenkontakt 12 ist mittels eines Bonddrahtes 14 mit einem zweiten elektrischen Anschluß 3 verbunden.

Die freien Oberflächen des Halbleiterkörpers 1 und Teilbereiche der elektrischen Anschlüsse 2 und 3 sind unmittelbar von einer Lumineszenzkonversionsumhüllung 5 umschlossen. Diese besteht bevorzugt aus einem für transparente Leuchtdiodenumhüllungen verwendbaren transparenten Kunststoff, der mit Leuchtstoff 6, bevorzugt anorganischer Leuchtstoff, für Weiß leuchtende Bauelemente bevorzugt Y₃Al₅O₁₂:Ce³⁺ (YAG:Ce), versetzt ist.

Das in Figur 2 dargestellte Ausführungsbeispiel eines erfindungsgemäßen Halbleiterbauelements unterscheidet sich von dem der Figur 1 dadurch, daß der Halbleiterkörper 1 und Teilbereiche der elektrischen Anschlüsse 2 und 3 anstatt von einer Lumineszenzkonversionsumhüllung von einer transparenten Umhüllung 15 umschlossen sind. Diese transparente Umhüllung 15 bewirkt keine Wellenlängenänderung der von dem Halbleiterkörper 1 ausgesandten Strahlung und besteht beispielsweise aus einem in der Leuchtdiodentechnik herkömmlich verwendeten Silikonoder Acrylatharz oder aus einem anderengeeigneten strahlungsdurchlässigen Material wie z. B. anorganisches Glas.

Auf diese transparente Umhüllung 15 ist eine Lumineszenzkonversionsschicht 4 aufgebracht, die, wie in der Figur 2 dargestellt, die gesamte Oberfläche der Umhüllung 15 bedeckt. Ebenso denkbar ist, daß die Lumineszenzkonversionsschicht 4 nur einen Teilbereich dieser Oberfläche bedeckt. Die Lumineszenzkonversionsschicht 4 besteht aus einem transparenten Silikonmaterial, der mit einem Leuchtstoff 6 versetzt ist.

Dieses Ausführungsbeispiel hat den besonderen Vorteil, daß für die gesamte von dem Halbleiterkörper ausgesandte Strahlung die Weglänge durch das Lumineszenzkonverionselement näherungsweise gleich groß ist. Dies spielt insbesondere dann eine bedeutende Rolle, wenn, wie oftmals der Fall, der genaue Farbton des von dem Halbleiterbauelement abgestrahlten Lichtes von dieser Weglänge abhängt.

Zur besseren Auskopplung des Lichtes aus der Lumineszenzkonversionsschicht 4 von Figur 2 kann auf einer Seitenfläche des Bauelements eine linsenförmige Abdeckung 29 (gestrichelt eingezeichnet) vorgesehen sein, die eine Totalreflexion der Strahlung innerhalb der Lumineszenzkonversionsschicht 4 reduziert. Diese linsenförmige Abdeckung 29 kann aus transparentem Kunststoff oder Glas bestehen und auf die Lumineszenzkonversionsschicht 4 beispielsweise aufgeklebt oder direkt als Bestandteil der Lumineszenzkonversionsschicht 4 ausgebildet sein.

Bei dem in Figur 3 dargestellten Ausführungsbeispiel sind der erste und zweite elektrische Anschluß 2,3 in ein lichtundurchlässiges evtl. vorgefertigtes Grundgehäuse 8 mit einer Ausnehmung 9 eingebettet. Unter "vorgefertigt" ist zu verstehen, daß das Grundgehäuse 8 bereits an den Anschlüssen 2,3 beispielsweise mittels Spritzguß fertig ausgebildet ist, bevor der Halbleiterkörper auf.den Anschluß 2 montiert wird. Das Grundgehäuse 8 besteht beispielsweise aus einem lichtundurchlässigen Kunststoff und die Ausnehmung 9 ist hinsichtlich ihrer Form als Reflektor 17 für die vom Halbleiterkörper im Betrieb ausgesandte Strahlung (ggf. durch geeignete Beschichtung der Innenwände der Ausnehmung 9) ausgebildet. Solche Grundgehäuse 8 werden insbesondere bei auf Leiterplatten oberflächenmontierbaren Leuchtdioden verwendet. Sie werden vor der Montage der Halbleiterkörper auf ein die elektrischen Anschlüsse 2,3 aufweisendes Leiterband (Leadframe) z. B. mittels Spritzgießen aufgebracht.

Die Ausnehmung 9 ist von einer Lumineszenzkonversionsschicht 4, beispielsweise eine separat hergestellte und auf dem Grundgehäuse 8 befestigte Abdeckplatte 17 aus Kunststoff abgedeckt. Als geeignete Materialien für die Lumineszenzkonversionsschicht 4 kommen wiederum die weiter oben im allgemeinen Teil der Beschreibung genannten Silikonmaterialien in Verbindung mit Leuchtstoffen in Frage. Die Ausnehmung 9 kann sowohl mit einem transparenten Kunststoff, mit einem anorganischen Glas oder mit Gas gefüllt als auch mit einem Vakuum versehen sein.

Wie bei dem Ausführungsbeispiel nach Figur 2 kann auch hier zur besseren Auskopplung des Lichtes aus der Lumineszenzkonversionsschicht 4 auf dieser eine linsenförmige Abdeckung 29 (gestrichelt eingezeichnet) vorgesehen sein, die eine Totalreflexion der Strahlung innerhalb der Lumineszenzkonversionsschicht 4 reduziert. Diese Abdeckung 29 kann aus transparentem Kunststoff bestehen und auf die Lumineszenzkonversionsschicht 4 beispielsweise aufgeklebt oder zusammen mit der Lumineszenzkonversionsschicht 4 einstückig ausgebildet sein.

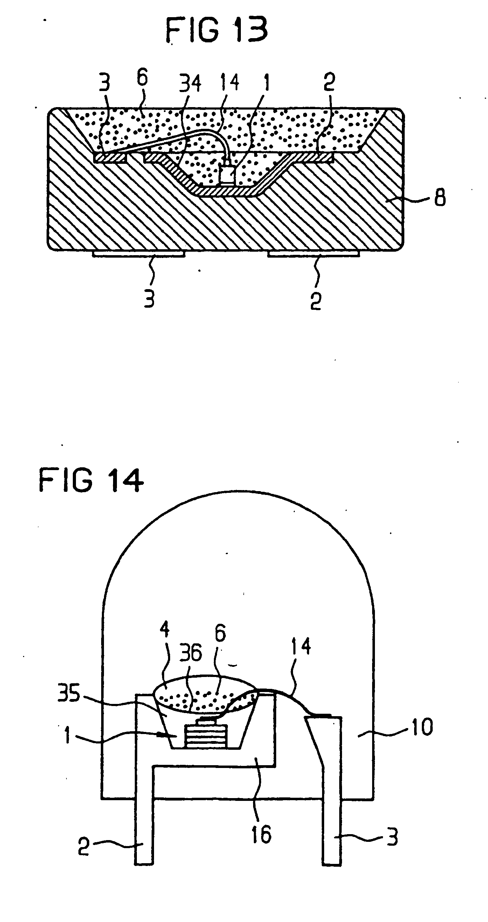

Bei einer besonders bevorzugten Ausführungsform ist die Ausnehmung 9, wie in Figur 10 gezeigt, mit einer Lumineszenzumhüllung 5 gefüllt, die das Lumineszenzkonversionselement bildet. Eine Abdeckplatte 17 und/oder eine linsenförmige Abdeckung 29 kann dann auch weggelassen sein. Weiterhin ist optional, wie in Figur 13 dargestellt, der erste elektrische Anschluß 2 z. B. durch Prägen im Bereich des Halbleiterkörpers 1 als Reflektorwanne 34 ausgebildet, die mit einer Lumineszenzkonversionsumhüllung 5 gefüllt ist.

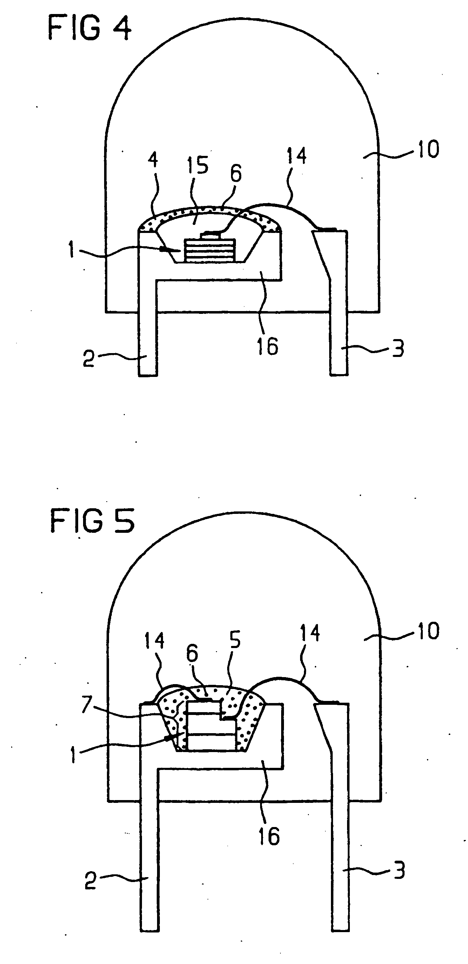

In Figur 4 ist als weiteres Ausführungsbeispiel eine sogenannte Radialdiode dargestellt. Hierbei ist der Halbleiterkörper 1 in einem als Reflektor ausgebildeten Teil 16 des ersten elektrischen Anschlußes 2 beispielsweise mittels Löten oder Kleben befestigt. Derartige Gehäusebauformen sind in der Leuchtdiodentechnik bekannt und bedürfen von daher keiner näheren Erläuterung.

Bei dem Ausführungsbeispiel von Figur 4 ist der Halbleiterkörper 1 von einer transparenten Umhüllung 15 umgeben, die, wie beim zweitgenannten Ausführungsbeispiel (Figur 2), keine Wellenlängenänderung der von dem Halbleiterkörper 1 ausgesandten Strahlung bewirkt und beispielsweise aus einem herkömmlich in der Leuchtdiodentechnik verwendeten transparenten Epoxidharz oder aus organischem Glas bestehen kann.

Auf dieser transparenten Umhüllung 15 ist eine Lumineszenzkonversionsschicht 4 aufgebracht. Als Material hierfür kommen beispielsweise wiederum die im Zusammenhang mit den vorgenannten Ausführungsbeispielen angeführten Silikonmaterialien in Verbindung mit Farbstoffen in Frage.

Der gesamte Aufbau, bestehend aus Halbleiterkörper 1, Teilbereiche der elektrischen Anschlüsse 2,3, transparente Umhüllung 15 und Lumineszenzkonversionsschicht 4, ist unmittelbar von einer weiteren transparenten Umhüllung 10 umschlossen, die keine Wellenlängenänderung der durch die Lumineszenzkonversionsschicht 4 hindurchgetretenen Strahlung bewirkt. Sie besteht beispielsweise wiederum aus einem herkömmlich in der Leuchtdiodentechnik verwendeten transparenten Epoxidharz oder aus anorganischem Glas.

Das in Figur 5 gezeigte Ausführungsbeispiel unterscheidet sich von dem von Figur 4 im wesentlichen dadurch, daß die freien Oberflächen des Halbleiterkörpers 1 unmittelbar von einer Lumineszenzkonversionsumhüllung 5 bedeckt sind, die wiederum von einer weiteren transparenten Umhüllung 10 umgeben ist. In Figur 5 ist weiterhin beispielhaft ein Halbleiterkörper 1 dargestellt, bei dem anstelle des Unterseitenkontaktes ein weiterer Kontakt auf der Halbleiterschichtenfolge 7 angebracht ist, der mittels eines zweiten Bonddrahtes 14 mit dem zugehörigen elektrischen Anschluß 2 oder 3 verbunden ist. Selbstverständlich sind derartige Halbleiterkörper 1 auch bei allen anderen hierin beschriebenen Ausführungsbeispielen einsetzbar. Umgekehrt ist natürlich auch bei dem Ausführungsbeispiel von Figur 5 ein Halbleiterkörper 1 gemäß den vorgenannten Ausführungsbeispielen verwendbar.

Der Vollständikeit halber sei an dieser Stelle angemerkt, daß selbstverständlich auch bei der Bauform nach Figur 5 analog zu dem Ausführungsbeispiel nach Figur 1 eine einstückige Lumineszenzkonversionsumhüllung 5, die dann an die Stelle der Kombination aus Lumineszenzkonversionsumhüllung 5 und weiterer transparenter Umhüllung 10 tritt, verwendet sein kann.

Bei dem Ausführungsbeispiel von Figur 6 ist eine Lumineszenzkonversionsschicht 4 (Materialien wie oben angegeben) direkt auf den Halbleiterkörper 1 aufgebracht. Dieser und Teilbereiche der elektrischen Anschlüsse 2,3 sind von einer weiteren transparenten Umhüllung 10 umschlossen, die keine wellenlängenänderung der durch die Lumineszenzkonversionsschicht 4 hindurchgetretenen Strahlung bewirkt und beispielsweise aus einem in der Leuchtdiodentechnik verwendbaren transparenten Epoxidharz oder aus Glas gefertigt ist.

Solche, mit einer Lumineszenzkonversionsschicht 4 versehenen Halbleiterkörper 1 ohne Umhüllung können natürlich vorteilhafterweise in sämtlichen aus der Leuchtdiodentechnik bekannten Gehäusebauformen (z. B. SMD-Gehäuse, Radial-Gehäuse (man vergleiche Figur 5)) verwendet sein.

Bei dem in Figur 14 dargestellten Ausführungsbeispiel eines erfindungsgemäßen Halbleiterbauelements ist auf dem Halbleiterkörper 1 ein transparentes Wannenteil 35 angeordnet, das über dem Halbleiterkörper 1 eine Wanne 36 aufweist. Das Wannenteil 35 besteht beispielsweise aus transparentem Epoxidharz oder aus anorganischem Glas und ist z. B. mittels Umspritzen der elektrischen Anschlüsse 2,3 einschließlich Halbleiterkörper 1 gefertigt. In dieser Wanne 36 ist eine Lumineszenzkonversionsschicht 4 angeordnet, in die Leuchtstoffe eingebunden sind. Das Wannenteil 35 kann selbstverständlicherweise auch separat hergestellt und anderweitig, z. B. an einem Gehäuseteil, über dem Halbleiterkörper 1 befestigt sein.

Bei sämtlichen der oben beschriebenen Ausführungsbeispiele kann zur Optimierung des Farbeindrucks des abstrahlten Lichts sowie zur Anpassung der Abstrahlcharakteristik das Lumineszenzkonversionselement (Lumineszenzkonversionsumhüllung 5 oder Lumineszenzkonversionsschicht 4), ggf. die transparente Umhüllung 15, und/oder ggf. die weitere transparente Umhüllung 10 lichtstreuende Partikel, vorteilhafterweise sogenannte Diffusoren aufweisen. Beispiele für derartige Diffusoren sind mineralische Füllstoffe, insbesondere CaF₂, TiO₂, SiO₂, CaCO₃ oder BaSO₄ oder auch organische Pigmente. Diese Materialien können auf einfache Weise den o. g. Kunststoffen zugesetzt werden.

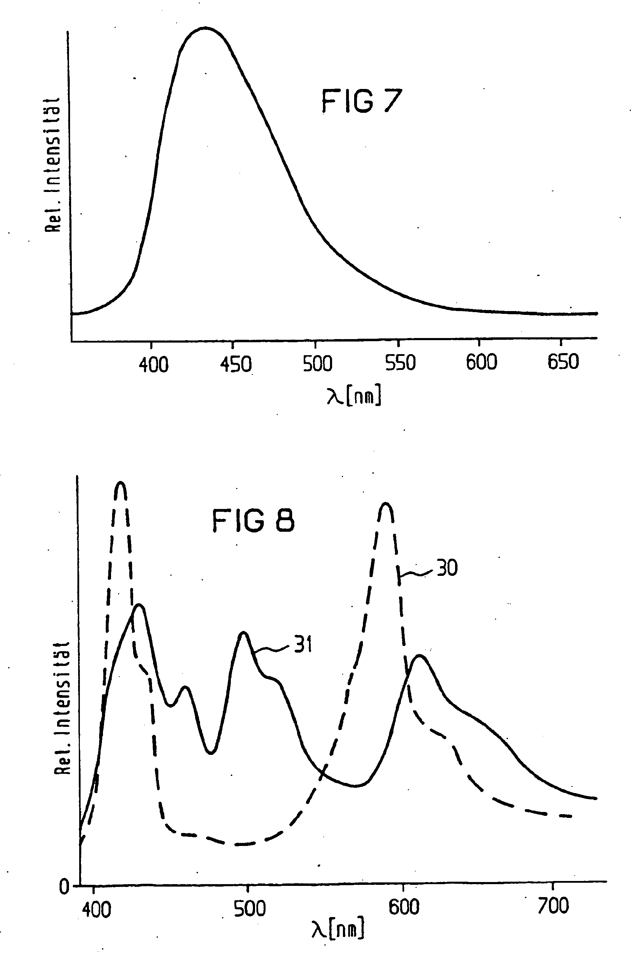

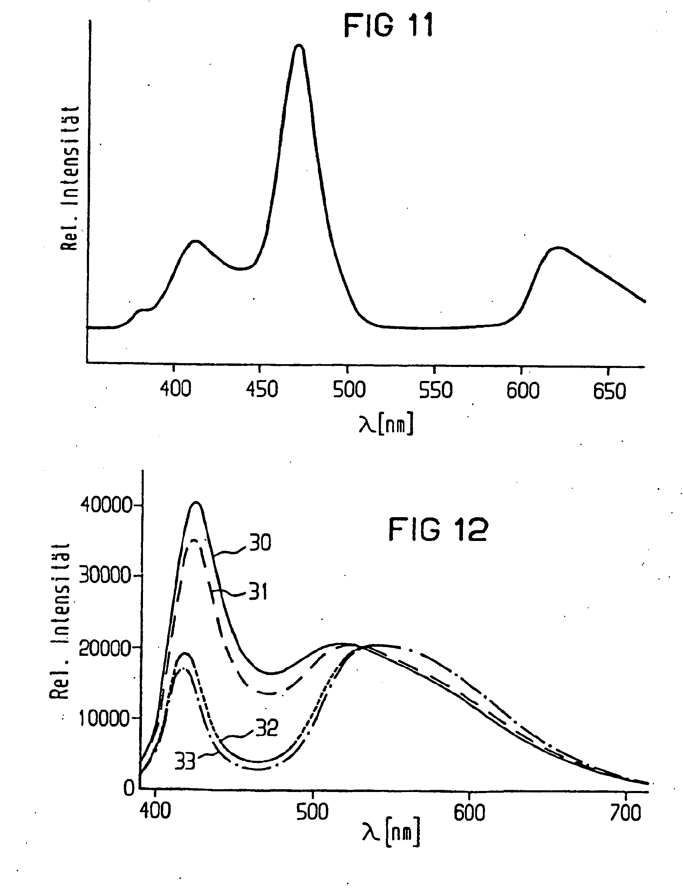

In den Figuren 7, 8 und 12 sind Emissionsspektren eines blaues Licht abstrahlenden Halbleiterkörpers (Fig. 7) (Lumineszenzmaximum bei λ ∼ 430 nm) bzw. von mittels eines solchen Halbleiterkörpers hergestellten Weiß leuchtenden erfindungsgemäßen Halbleiterbauelementen (Fig. 8 und 12) gezeigt. An der Abszisse ist jeweils die Wellenänge λ in nm und auf der Ordinate ist jeweils eine relative Elektrolumineszenz(EL)-Intensität aufgetragen.

Von der vom Halbeiterkörper ausgesandten Strahlung nach Figur 7 wird nur ein Teil in einen längerwelligen Wellenlängenbereich konvertiert, so daß als Mischfarbe weißes Licht entsteht. Die gestrichelte Linie 30 in Figur 8 stellt ein Emissionsspektrum von einem erfindungsgemäßen Halbleiterbauelement dar, das Strahlung aus zwei komplementären Wellenlängenbereichen (Blau und Gelb) und damit insgesamt weißes Licht aussendet. Das Emissionsspektrum weist hier bei Wellenlängen zwischen ca. 400 und ca. 430 nm (Blau) und zwischen ca. 550 und ca. 580 nm (Gelb) je ein Maximum auf. Die durchgezogene Linie 31 repräsentiert das Emissionsspektrum eines erfindungsgemäßen Halbleiterbauelements, das die Farbe Weiß aus drei Wellenlängenbereichen (additives Farbtripel aus Blau, Grün und Rot) mischt. Das Emissionsspektrum weist hier beispielsweise bei den Wellenlängen von ca. 430 nm (Blau), ca. 500 nm (Grün) und ca. 615 nm (Rot) je ein Maximum auf.

Desweiteren ist in Figur 11 ein Emissionsspektrum eines erfindungsgemäßen Halbleiterbauelements dargestellt, das mischfarbiges Licht aus blauem Licht (Maximum bei einer Wellenlänge von ca. 470 nm) und rotem Licht (Maximum bei einer Wellenlänge von ca. 620 nm) abstrahlt. Der Gesamtfarbeindruck des abgestrahlten Lichtes für das menschliche Auge ist Magenta. Das vom Halbleiterkörper abgestrahlte Emissionsspektrum entspricht hier wiederum dem von Figur 7.

Figur 12 zeigt ein Weiß leuchtendes, zur Illustration angeführtes Halbleiterbauelement, das mit einem ein Emissions-Spektrum gemäß Figur 7 aussendenden Halbleiterkörper versehen ist und bei dem als Leuchtstoff YAG:Ce verwendet ist. Von der vom Halbeiterkörper ausgesandten Strahlung nach Figur 7 wird nur ein Teil in einen längerwelligen Wellenlängenbereich konvertiert, so daß als Mischfarbe weißes Licht entsteht. Die verschiedenartig gestrichelten Linien 30 bis 33 von Figur 8 stellen Emissionsspektren von Halbleiterbauelementen dar, bei denen das Lumineszenzkonversionselement, in diesem Fall eine Lumineszenzkonversionsumhüllung aus Epoxidharz, unterschiedliche YAG:CeKonzentrationen aufweist. Jedes Emissionsspektrum weist zwischen λ = 420 nm und λ = 430 nm, also im blauen Spektralbereich, und zwischen λ = 520 nm und λ = 545 nm, also im grünen spektralbereich, jeweils ein Intensitätsmaximum auf, wobei die Emissionsbanden mit dem längerwelligen Intensitätsmaximum zu einem großen Teil im gelben Spektralbereich liegen. Das Diagramm von Figur 12 verdeutlicht, daß bei dem erfindungsgemäßen Halbleiterbauelement auf einfache Weise durch Veränderung der Leuchtstoffkonzentration im Epoxidharz der CIE-Farbort des weißen Lichtes verändert werden kann.

Ein weiterer besonderer Vorteil der oben genannten anorganischen Leuchtstoffe ergibt sich daraus, daß die Leuchtstoffkonzentration z.B. im Epoxidharz nicht wie bei organischen Farbstoffen durch die Löslichkeit begrenzt wird. Dadurch sind keine großen Dicken von Lumineszenzkonversionselementen nötig.

Die Erläuterung des erfindungsgemäßen Halbleiterbauelements anhand der oben beschriebenen Ausführungsbeispiele ist natürlich nicht als Beschränkung der Erfindung auf diese zu betrachten. Als Halbleiterkörper, wie beispielsweise Leuchtdioden-Chips oder Laserdioden-Chips, ist beispielsweise auch eine Polymer-LED zu verstehen, die ein enstprechendes Strahlungsspektrum aussendet.

## Patentansprüche

1. Halbleiterbauelement mit einem Halbleiterkörper (1), der im Betrieb des Halbleiterbauelements elektromagnetische Strahlung aussendet, mit mindestens einem ersten und mindestens einem zweiten elektrischen Anschluß (2, 3), die mit dem Halbleiterkörper (1) elektrisch leitend verbunden sind, und mit einem Lumineszenzkonversionselement, das mindestens einen Leuchtstoff aufweist, wobei
der Halbleiterkörper (1) eine Halbleiterschichtenfolge (7) aufweist, die im Betrieb des Halbleiterbauelements elektromagnetische Strahlung aussendet, die bei einer Wellenlänge λ ≤ 520nm ein relatives Intensitäts maximum aufweist, und
das Lumineszenzkönversionselement eine aus dem ersten Wellenlängenbereich stammende Strahlung in Strahlung eines zweiten Wellenlängenbereiches umwandelt, derart, daß das Halbleiterbauelement mischfarbiges Licht, bestehend aus Strahlung des ersten Wellenlängenbereiches und Strahlung des zweiten Wellenlängenbereiches aussendet, **dadurch gekennzeichnet, dass** das Lumineszenzkonversionselement eine teiltransparente Lumineszenzkonversionsumhüllung oder Lumineszenzkonversionsschicht ist, die aus einem Silikonmaterial, das mit Leuchtstoff versetzt ist, hergestellt ist und zumindest einen Teil des Halbleiterkörpers umschließt.

2. Halbleiterbauelement nach Anspruch 1, **dadurch gekennzeichnet, daß** das Lumineszenzkonversionselement Strahlung des ersten Wellenlängenbereichs in Strahlung mehrerer zweiter Wellenlängenbereiche aus voneinander verschiedenen spektralen Teilbereichen umwandelt, derart, daß das Halbleiterbauelement mischfarbiges Licht, bestehend aus Strahlung des erstenWellenlängenbereiches und Strahlung der zweiten Wellenlängenbereicheaussendet.

3. Halbleiterbauelement nach Anspruch 1, **dadurch gekennzeichnet, daß** der erste wellenlängenbereich und der zweite Wellenlängenbereich zumindest teilweise in zueinander komplementärfarbigen Spektralbereichen liegen, so daß weißes Licht erzeugt wird.

4. Halbleiterbauelement nach einem der Ansprüche 1 bis 3, **dadurch gekennzeichnet, daß** das Lumineszenzkonversionselement in Hauptabstrahlrichtung des Halbleiterbauelements gesehen im Wesentlichen dem Halbleiterkörper (1) nachgeordnet ist.

5. Halbleiterbauelement nach einem der Ansprüche 1 bis 4, **dadurch gekennzeichnet, daß** die Lumineszenzkonversionsschicht (4) auf dem Halbleiterkörper aufgebracht ist.

6. Halbleiterbauelement nach Anspruch 2 oder nach Anspruch 2 in Verbindung mit einem der Ansprüche 4 und 5, **dadurch gekennzeichnet, daß** der vom Halbleiterkörper ausgesandte erste Wellenlängenbereich und zwei zweite Wellenlängenbereiche ein additives Farbtripel ergeben, derart, daß in Betrieb des Halbleiterbauelements von diesem weißes Licht abgestrahlt wird.

7. Halbleiterbauelement nach einem der Ansprüche 1 bis 6, **dadurch gekennzeichnet, daß** die vom Halbleiterkörper (1) ausgesandte Strahlung im blauen Spektralbereich bei einer Wellenlänge zwischen 420nm und 460 nm ein Lumineszenz-Intentsitätsmaximum aufweist.

8. Halbleiterbauelement nach einem der Ansprüche 1 bis 7, **dadurch gekennzeichnet, daß** der Halbleiterkörper (1) in einer Ausnehmung (9) eines Grundgehäuses (8) angeordnet ist und daß die Ausnehmung (9) zumindest teilweise von dem Lumineszenzkonversionselement ausgefüllt ist.

9. Halbleiterbauelement nach einem der Ansprüche 1 bis 8, **dadurch gekennzeichnet, daß** das Lumineszenzkonversionselement mehrere Schichten mit unterschiedlichem Wellenlängenkonversionseigenchaften aufweist.

10. Halbleiterbauelement nach einem der Ansprüche 1 bis 9, **dadurch gekennzeichnet , dass** das Lumineszenzkonversionselement mit mehreren verschiedenen Leuchtstoffen (6) versehen ist.

11. Halbleiterbauelement nach einem der Ansprüche 1 bis 10, **dadurch gekennzeichnet, daß** das Lumineszenzkonversionselement Farbstoffmoleküle mit und ohne Wellenlängenkonversionswirkung aufweist.

12. Halbleiterbauelement nach einem der Ansprüche 1 bis 11, **dadurch gekennzeichnet, daß** das Lumines zenzkonversionselement und/oder eine transparente Umhüllung (10,15) lichtstreuende Partikel ausweist.

## Claims

1. Semiconductor component having a semiconductor body (1), which emits electromagnetic radiation during operation of the semiconductor component, having at least one first and at least one second electrical connection (2, 3), which are electrically conductively connected to the semiconductor body (1), and having a luminescence conversion element, which has at least one luminescent material, wherein
- the semiconductor body (1) has a semiconductor layer sequence (7), which emits electromagnetic radiation during operation of the semiconductor component, which radiation has a relative intensity maximum at a wavelength λ ≤ 520nm, and
- the luminescence conversion element converts a radiation originating from the first wavelength range into radiation of a second wavelength range in such a way that the semiconductor component emits mixed-coloured light, comprising radiation of the first wavelength range and radiation of the second wavelength range, **characterized in that**
- the luminescence conversion element is a partly transparent luminescence conversion encapsulation or luminescence conversion layer which is produced from a silicone material admixed with luminescent material and encloses at least one part of the semiconductor body.

2. Semiconductor component according to Claim 1, **characterized in that** the luminescence conversion element converts radiation of the first wavelength range into radiation of a plurality of second wavelength ranges from mutually different spectral subregions, in such a way that the semiconductor component emits mixed-coloured light, consisting of radiation of the first wavelength range and radiation of the second wavelength ranges.

3. Semiconductor component according to Claim 1, **characterized in that** the first wavelength range and the second wavelength range lie at least partially in mutually complementarily colored spectral regions, with the result that white light is produced.

4. Semiconductor component according to one of Claims 1 to 3, **characterized in that** the luminescence conversion element is arranged essentially downstream of the semiconductor body (1), as seen in the main radiating direction of the semiconductor component.

5. Semiconductor component according to one of Claims 1 to 4, **characterized in that** the luminescence conversion layer (4) is applied on the semiconductor body.

6. Semiconductor component according to Claim 2 or according to Claim 2 in conjunction with either of Claims 4 and 5, **characterized in that** the first wavelength range emitted by the semiconductor body and two second wavelength ranges produce an additive color triad, in such a way that white light is radiated by the semiconductor component during operation thereof.

7. Semiconductor component according to one of Claims 1 to 6, **characterized in that** the radiation emitted by the semiconductor body (1) in the blue spectral region has a luminescence intensity maximum at a wavelength of between 420 nm and 460 nm.

8. Semiconductor component according to one of Claims 1 to 7, **characterized in that** the semiconductor body (1) is arranged in a recess (9) in a base housing (8), and **in that** the recess (9) is at least partially filled by the luminescence conversion element.

9. Semiconductor component according to one of Claims 1 to 8, **characterized in that** the luminescence conversion element has a plurality of layers having different wavelength conversion properties.

10. Semiconductor component according to one of Claims 1 to 9, **characterized in that** the luminescence conversion element is provided with a plurality of different luminescent materials (6).

11. Semiconductor component according to one of Claims 1 to 10, **characterized in that** the luminescence conversion element has dye molecules with and without wavelength conversion effect.

12. Semiconductor component according to one of Claims 1 to 11, **characterized in that** the luminescence conversion element and/or a transparent encapsulation (10, 15) have/has light-diffusing particles.

## Revendications

1. Dispositif semi-conducteur comportant un corps semi-conducteur (1), qui lors du fonctionnement du dispositif semi-conducteur émet un rayonnement électromagnétique, comportant au moins un premier et au moins un deuxième branchement électrique (2, 3), qui sont reliés au corps semi-conducteur (1) de manière électriquement conductrice, et comportant un élément de conversion de luminescence, qui présente au moins une substance luminescente, dans lequel
- le corps semi-conducteur (1) présente une succession (7) de couches semi-conductrices, qui émet lors du fonctionnement du dispositif semi-conducteur un rayonnement électromagnétique qui présente à une longueur d'onde λ ≤ 520 nm une intensité maximale relative, et
- l'élément de conversion de luminescence convertit un rayonnement provenant de la première plage de longueur d'onde en un rayonnement d'une deuxième plage de longueur d'onde, de telle sorte que le dispositif semi-conducteur émette une lumière de couleur mélangée, constituée du rayonnement de la première plage de longueur d'onde et du rayonnement de la deuxième plage de longueur d'onde, **caractérisé en ce que**
- l'élément de conversion de luminescence est une couche de conversion de luminescence ou une enveloppe de conversion de luminescence partiellement transparente, laquelle est fabriquée en un matériau de silicone auquel la substance luminescente est ajoutée, et laquelle entoure au moins une partie du corps semi-conducteur.

2. Dispositif semi-conducteur selon la revendication 1, **caractérisé en ce que** l'élément de conversion de luminescence convertit un rayonnement de la première plage de longueur d'onde en un rayonnement de plusieurs deuxièmes plages de longueur d'onde à partir de régions de spectre partielles différentes les unes des autres, de telle sorte que le dispositif semi-conducteur émette une lumière de couleur mélangée, constituée du rayonnement de la première plage de longueur d'onde et du rayonnement des deuxièmes plages de longueur d'onde.

3. Dispositif semi-conducteur selon la revendication 1, **caractérisé en ce que** la première plage de longueur d'onde et la deuxième plage de longueur d'onde sont situées au moins partiellement dans des régions de spectre de couleurs complémentaires l'une à l'autre, de sorte qu'une lumière blanche soit produite.

4. Dispositif semi-conducteur selon une des revendications 1 à 3, **caractérisé en ce que** l'élément de conversion de luminescence est disposé essentiellement après le corps semi-conducteur (1) vu dans la direction de rayonnement principal du dispositif semi-conducteur.

5. Dispositif semi-conducteur selon une des revendications 1 à 4, **caractérisé en ce que** la couche de conversion de luminescence (4) est appliquée sur le corps semi-conducteur.

6. Dispositif semi-conducteur selon la revendication 2 ou selon la revendication 2 en combinaison avec une des revendications 4 et 5, **caractérisé en ce que** la première plage de longueur d'onde émise par le corps semi-conducteur et deux deuxièmes plages de longueur d'onde donnent un triplet de luminophores additif, de telle sorte que lors du fonctionnement du dispositif semi-conducteur une lumière blanche soit émise par celle-ci.

7. Dispositif semi-conducteur selon l'une des revendications 1 à 6, **caractérisé en ce que** le rayonnement émis par le corps semi-conducteur (1) présente un maximum d'intensité de luminescence dans la région spectrale bleue avec une longueur d'onde comprise entre 420 nm et 460 nm.

8. Dispositif semi-conducteur selon une des revendications 1 à 7, **caractérisé en ce que** le corps semi-conducteur (1) est disposé dans un évidement (9) d'un logement de base (8) et **en ce que** l'évidement (9) est rempli au moins partiellement par l'élément de conversion de luminescence.

9. Dispositif semi-conducteur selon une des revendications 1 à 8, **caractérisé en ce que** l'élément de conversion de luminescence présente plusieurs couches avec des propriétés de conversion de longueur d'onde différentes.

10. Dispositif semi-conducteur selon une des revendications 1 à 9, **caractérisé en ce que** l'élément de conversion de luminescence est pourvu de plusieurs substances luminescentes (6) différentes.

11. Dispositif semi-conducteur selon l'une des revendications 1 à 10, **caractérisé en ce que** l'élément de conversion de luminescence présente des molécules de colorant avec et sans effet de conversion de longueur d'onde.

12. Dispositif semi-conducteur selon une des revendications 1 à 11, **caractérisé en ce que** l'élément de conversion de luminescence et/ou un enveloppage transparent (10, 15) présente des particules diffusant la lumière.
